(19) Europäisches Patentamt

European Patent Office

Office européen des brevets

(11) Veröffentlichungsnummer: **0 254 873 B1**

(12) **EUROPÄISCHE PATENTSCHRIFT**

(45) Veröffentlichungstag der Patentschrift: **06.05.92**

(21) Anmeldenummer: **87109104.7**

(22) Anmeldetag: **24.06.87**

(51) Int. Cl.⁵: **H03F 3/30**, H03F 1/52

(54) **Schaltungsanordnung mit einer Brückenendstufe.**

(30) Priorität: **05.07.86 DE 3622713**

(43) Veröffentlichungstag der Anmeldung:
**03.02.88 Patentblatt 88/05**

(45) Bekanntmachung des Hinweises auf die
Patenterteilung:
**06.05.92 Patentblatt 92/19**

(84) Benannte Vertragsstaaten:
**DE FR GB IT SE**

(56) Entgegenhaltungen:
**EP-A- 0 176 708**
**EP-A- 0 201 728**
**DE-A- 2 710 762**
**FR-A- 2 498 844**
**US-A- 4 053 996**

(73) Patentinhaber: **Blaupunkt-Werke GmbH**
**Robert-Bosch-Strasse 200**
**W-3200 Hildesheim(DE)**

(72) Erfinder: **Wieschhoff, Reinhard**
**Brehmestrasse 59**
**W-3200 Hildesheim(DE)**
Erfinder: **Rinne, Andreas**
**Schmiedestrasse 4**
**W-3226 Westfeld(DE)**
Erfinder: **Pagany, Hubertus**
**Hohnsen 10**
**W-3200 Hildesheim(DE)**

(74) Vertreter: **Eilers, Norbert, Dipl.-Phys.**
**Robert-Bosch-Strasse 200**
**W-3200 Hildesheim(DE)**

## Beschreibung

Die Erfindung geht aus von einer Schaltungsanordnung nach der Gattung des Hauptanspruches.

Insbesondere bei Autoradios treten Probleme dadurch auf, daß bei gegebener Größe des Gerätes sowie maximal zulässiger Gehäusetemperatur der Verlustleistung und damit auch der Ausgangsleistung Grenzen gesetzt sind.

Aus der US-A-4 053 996 ist eine Schutzschaltung für eine Brückenendstufe bekannt, bei der die Vorspannung der beiden Einzelendstufen in Abhängigkeit von der Temperatur geregelt wird. Es sind auch Schutzschaltungen bekannt geworden, die bei Erreichen einer vorgegebenen Temperatur den Signalfluß unterbrechen. So ist aus der FR-A-2 498 844 eine Schutzschaltung für eine Endstufe bekannt, bei der ein Thermoschalter nach seiner Aktivierung Schalttransistoren in die Sättigung steuert und damit Signalwege am Eingang des Verstärkers gegen Masse kurzschließt, um sie nach dem Abkühlen wieder freizugeben. Diese bekannte Maßnahme ist jedoch nicht besonders vorteilhaft, da der Benutzer eines Autoradios das Gerät während der Abkühlphase nicht benutzen kann.

Die erfindungsgemäße Schaltungsanordnung mit den Merkmalen des Hauptanspruchs hat den Vorteil, daß eine unzulässig hohe Gehäusetemperatur trotz großer maximaler Ausgangsleistung der Endstufen verhindert wird, wobei ein Betrieb der Endstufen - wenn auch mit verminderter Ausgangsleistung - fortgesetzt wird.

Besonders vorteilhaft ist ferner, daß sich die erfindungsgemäße Schaltungsanordnung mit wenigen zusätzlichen Bauelementen verwirklichen läßt.

Durch die in den Unteransprüchen aufgeführten Maßnahmen sind vorteilhafte Weiterbildungen und Verbesserungen der im Hauptanspruch angegebenen Schaltungsanordnung möglich.

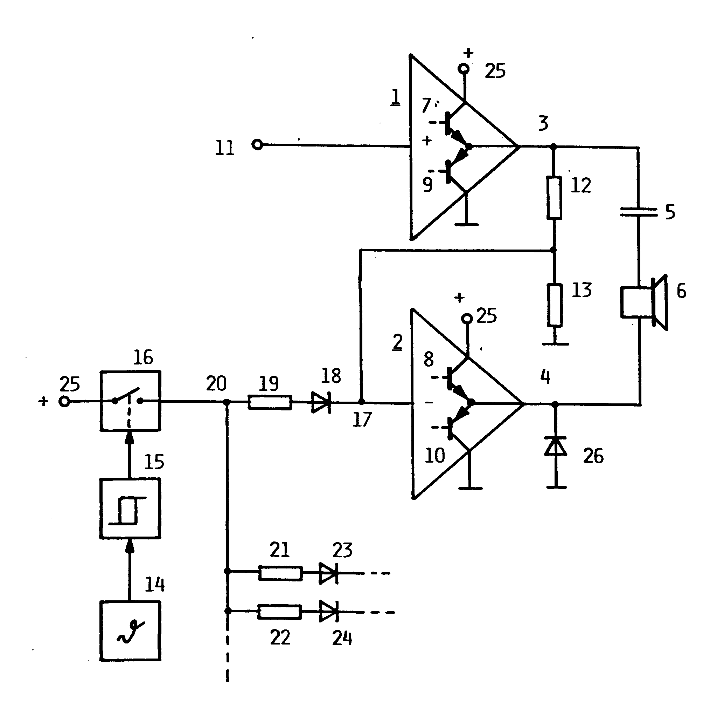

Ein Ausführungsbeispiel der Erfindung ist in der Zeichnung schematisch dargestellt und in der nachfolgenden Beschreibung näher erläutert.

Die beiden Gegentaktverstärker 1, 2 bilden eine Brückenendstufe mit A/B-Betrieb. Die Ausgänge 3, 4 der Gegentaktverstärker 1, 2 bilden den Ausgang der Brückenendstufe, an den über einen bipolaren Kondensator 5 ein Lautsprecher 6 bzw. eine Lautsprechergruppe angeschlossen ist.

Die Gegentaktverstärker 1, 2 können in an sich bekannter Weise als komplementäre oder quasi komplementäre Endstufe aufgebaut sein. Da derartige Schaltungen hinreichend bekannt sind, sind in der Figur lediglich jeweils die beiden Endtransistoren 7, 9 und 8, 10 angedeutet. Über einen nichtinvertierenden Eingang 11 wird das wiederzugebende Audiosignal dem Gegentaktverstärker 1 zugeführt. Das Ausgangssignal des Gegentaktverstärkers 1 wird über einen Spannungsteiler 12, 13 dem invertierenden Eingang des Gegentaktverstärkers 2 zugeführt. Bei entsprechender Dimensionierung des Spannungsteilers 12, 13 ergeben sich an den Ausgängen 3, 4 der Gegentaktverstärker 1, 2 gegenphasige Signale mit gleicher Amplitude. Eine Einspeisung des phasenrichtigen Signals in den Gegentaktverstärker 2 kann auch in an sich bekannter Weise über Gegenkopplungsnetzwerke der Gegentaktverstärker 1, 2 erfolgen. Zwischen den Ausgängen 3, 4 liegt also ein Signal mit doppelter Amplitude, das über den bipolaren Kondensator C dem Lautsprecher 6 zugeführt wird.

Ein Temperatursensor 14 steht in wärmeleitender Verbindung mit einem Kühlkörper für die Gegentaktverstärker 1, 2. Als Temperatursensor eignet sich beispielsweise ein NTC- oder ein PTC-Widerstand, der von einem vorgegebenen Strom durchflossen wird. Der Spannungsabfall an dem Temperatursensor wird einem Schmitt-Trigger 15 zugeführt, dessen Schwellwerte derart eingestellt sind, daß bei Erreichen der höchst zulässigen Temperatur ein an den Ausgang des Schmitt-Triggers 15 angeschlossener Schalter 16 leitend wird. Der Schalter 16 verbindet den Eingang 17 des Gegentaktverstärkers 2 über eine Diode 18 und einen Widerstand 19 mit dem positiven Pol 25 der Betriebsspannungsquelle. Dadurch wird der Transistor 10 im Gegentaktverstärker 2 unabhängig von der Größe des über den Widerstand 12, 13 zugeführten Signals in den Sättigungszustand gesteuert. Eine dem Ausgang 4 parallelgeschaltete Diode 26 ermöglicht einen Stromfluß in entgegengesetzter Richtung.

Durch die damit bewirkte Verbindung des Ausgangs 4 des Gegentaktverstärkers 2 mit Masse arbeitet die Endstufe jetzt wie eine Einfachendstufe; das dem Lautsprecher 6 zugeführte Ausgangssignal weist nunmehr die halbe Amplitude auf, so daß nur noch ein Viertel der Leistung abgegeben wird. Damit wird auch die Verlustleistung bei im wesentlichen gleichen Wirkungsgrad auf ein Viertel reduziert.

Die gesamte Anordnung einschließlich des Kühlkörpers ist derart ausgelegt, daß bei einem Viertel der Gesamtleistung eine Abkühlung unter die höchst zulässige Temperatur erfolgt. Damit die beschriebene Leistungsumschaltung nicht zu oft erfolgt, wird jedoch der Schalter 16 erst wieder bei einer Temperatur geöffnet, die deutlich unter der höchst zulässigen Temperaturliegt. Hierzu ist der Schmitt-Trigger 15 mit einer entsprechenden Hysterese versehen.

Üblicherweise sind die Endstufen mehrerer Kanäle mit einem gemeinsamen Kühlkörper versehen. Es ist daher bei dem Ausführungsbeispiel vorgesehen, daß die aus dem Thermosensor 14, dem Schmitt-Trigger 15 sowie dem Schalter 16 bestehende Steuerschaltung die Brückenendstufen mehrerer Kanäle steuert, dazu können an den Schaltungspunkt 20 uber Widerstände 21, 22 und Dioden 23, 24 weitere Brückenendstufen angeschlossen werden. Dieses kann beispielsweise eine Endstufe bei normalem Stereoempfang sein. Es können jedoch auch beispielsweise drei weitere Kanäle bei insgesamt vierkanaliger Wiedergabe angeschlossen werden.

Der Schalter 16 ist in der Figur lediglich durch ein Schaltersymbol dargestellt. Es eignet sich jedoch vorzugsweise hierfür ein Halbleiterschalter, wie beispielsweise ein Transistor. Damit beim Umschalten keine Knackgeräusche auftreten, kann die Ausgangsspannung des Schmitt-Triggers 15 der Steuerelektrode des Schalters 16 über einen nicht dargestellten Tiefpaß zugeführt werden, so daß ein allmählicher Übergang zwischen dem leitenden und dem nichtleitenden Zustand des Schalters 16 erfolgt.

## Patentansprüche

1. Schaltungsanordnung zur Vermeidung einer Überhitzung einer aus zwei Endstufen (1, 2) bestehenden Brückenendstufe, insbesondere in einem Autoradio, mit einer Temperaturerfassungsschaltung (14, 15), dadurch gekennzeichnet, daß in Abhängigkeit von der Temperatur der Endstufen (1, 2) eine der Endstufen (2) über die Temperaturerfassungsschaltung (14, 15) in einen Sättigungszustand steuerbar ist, wobei die andere Endstufe (1) als Einfachendstufe weiterarbeitet.

2. Schaltungsanordnung nach Anspruch 1, dadurch gekennzeichnet, daß die Temperaturerfassungsschaltung einen Temperatursensor (14) und einen Schwellwertschalter (15) aufweist, daß der Temperatursensor (14) in wärmeleitender Verbindung mit der Endstufe (1, 2) steht, daß das Ausgangssignal des Temperatursensors (14) über den Schwellwertschalter (15) als Steuerspannung einem Schalter (16) zugeführt ist, der zwischen einem Pol (25) einer Betriebsspannungsquelle und dem Steuereingang (17) des Brückenzweiges (2) liegt.

3. Schaltungsanordnung nach Anspruch 2, dadurch gekennzeichnet, daß der Schalter (16) ein elektronischer Schalter ist und die Steuerspannung über einen Tiefpaß zugeführt ist.

4. Schaltungsanordnung nach Anspruch 2, dadurch gekennzeichnet, daß der Schwellwertschalter (15) ein Schmitt-Trigger ist.

5. Schaltungsanordnung nach einem der vorhergehenden Ansprüche, dadurch gekennzeichnet, daß zwischen dem Schalter (16) und dem Steuereingang (17) der gesteuerten Endstufe (2) eine Diode (18) angeordnet ist, welche bei nichtleitendem Schalter (16) gesperrt ist.

6. Schaltungsanordnung nach Anspruch 5, dadurch gekennzeichnet, daß in Reihe mit der Diode (18) ein Widerstand (19) angeordnet ist.

7. Schaltungsanordnung nach einem der vorhergehenden Ansprüche 5 oder 6, dadurch gekennzeichnet, daß an den Schalter (16) über weitere Dioden (23, 24) und gegebenenfalls über weitere Widerstände (21, 22) die Steuereingänge von gesteuerten Endstufen weiterer Brückenendstufen angeschlossen sind.

8. Schaltungsanordnung nach einem der vorhergehenden Ansprüche, dadurch gekennzeichnet, daß der weiter arbeitenden Endstufe (1) ein Audiosignal zuführbar ist und das Ausgangssignal dieser Endstufe (1) zur Steuerung der Endstufe (2), welche temperaturabhängig gesteuert wird, herangezogen wird.

9. Schaltungsanordnung nach einem der vorhergehenden Ansprüche, dadurch gekennzeichnet, daß der Temperatursensor (14) auf einem Kühlkörper für die Endstufen angeordnet ist.

10. Schaltungsanordnung nach Anspruch 1, dadurch gekennzeichnet, daß der Ausgang der gesteuerten Endstufe (2) über eine Diode (26) mit einem Pol der Betriebsspannungsquelle verbunden ist, wobei die Diode (16) derart gepolt ist, daß sie beim Betrieb der Endstufe gesperrt ist.

## Claims

1. Circuit arrangement for avoiding overheating of a bridge output stage consisting of two output stages (1, 2), in particular in a car radio, having a temperature sensor circuit (14, 15), characterised in that as a function of the temperature of the output stages (1, 2) one of the output stages (2) can be driven into a saturation state by means of the temperature sensor circuit (14, 15), the other output stage (1) continuing to operate as a single output stage.

2. Circuit arrangement according to Claim 1, characterised in that the temperature sensor circuit has a temperature sensor (14) and a threshold value switch (15), in that the temperature sensor (14) has a heat-conducting connection to the output stage (1, 2), and in that the output signal of the temperature sensor (14) is fed via the threshold value switch (15) to a switch (16) as a control voltage, said switch (16) being located between a pole (25) of an operating voltage source and the control input (17) of the bridge branch (2).

3. Circuit arrangement according to Claim 2, characterised in that the switch (16) is an electronic switch and the control voltage is fed via a low-pass filter.

4. Circuit arrangement according to Claim 2, characterised in that the threshold value switch (15) is a Schmitt Trigger.

5. Circuit arrangement according to one of the preceding claims, characterised in that arranged between the switch (16) and the control input (17) of the controlled output stage (2) is a diode (18) which is blocked when the switch (16) is nonconductive.

6. Circuit arrangement according to Claim 5, characterised in that a resistor (19) is arranged in series with the diode (18).

7. Circuit arrangement according to one of the preceding Claims 5 or 6, characterised in that the control inputs of controlled output stages of further bridge output stages are connected to the switch (16) via further diodes (23, 24) and, if appropriate, via further resistors (21, 22).

8. Circuit arrangement according to one of the preceding claims, characterised in that an audio signal can be fed to the output stage (1) which continues to operate and the output signal of this output stage (1) is used to control the output stage (2) which is controlled as a function of temperature.

9. Circuit arrangement according to one of the preceding claims, characterised in that the temperature sensor (14) is arranged on a heat sink for the output stages.

10. Circuit arrangement according to Claim 1, characterised in that the output of the controlled output stage (2) is connected via a diode (26) to a pole of the operating voltage source, the diode (16) being poled in such a way that it is blocked during the operation of the output stage.

**Revendications**

1. Circuit pour éviter la surchauffe d'un étage de sortie monté en pont comprenant deux étages de sortie (1, 2), notamment pour un auto-radio avec un circuit de détection de température (14, 15),
caractérisé en ce qu'en fonction de la température des étages de sortie (1, 2), l'un des étages de sortie (2) peut être commandé à l'état de saturation par le circuit de détection de température (14, 15), l'autre étage de sortie (1) continuant à fonctionner comme étage de sortie simple.

2. Circuit selon la revendication 1, caractérisé en ce que le circuit de détection de température comporte un détecteur de température (14) et un circuit à seuil (15), le détecteur de température (14) étant en communication de conduction thermique avec les étages de sortie (1, 2) et le signal de sortie du détecteur de température (14) est appliqué par le commutateur à seuil (15) sous la forme d'une tension de commande à un commutateur (16) monté entre un pôle (25) d'une source de tension de fonctionnement et l'entrée de commande (17) de la branche (2) du montage en pont.

3. Circuit selon la revendication 2, caractérisé en ce que le commutateur (16) est un commutateur électronique et la tension de commande lui est fournie par l'intermédiaire d'un filtre passe-bas.

4. Circuit selon la revendication 2, caractérisé en ce que le commutateur à seuil (15) est un déclencheur de Schmitt.

5. Circuit selon l'une des revendications précédentes, caractérisé en ce qu'entre le commutateur (16) et l'entrée de commande (17) de l'étage de sortie commandé (2) il est prévu une diode (18) qui se bloque lorsque le commutateur (16) n'est pas conducteur.

6. Circuit selon la revendication 5, caractérisé par une résistance (19) montée en série sur la diode (18).

7. Circuit selon l'une quelconque des revendications 5 ou 6, caractérisé en ce que les entrées de commande des étages de sortie commandés d'autres étages de sortie en pont sont reliées au commutateur (16) par d'autres diodes (23, 24) et le cas échéant d'autres résistances (21, 22).

8. Circuit selon l'une des revendications précédentes, caractérisé en ce que l'étage de sortie (1) qui continue de fonctionner reçoit un signal audio et le signal de sortie de cet étage de sortie (1) sert à la commande de l'étage de sortie (2) qui est commandé en fonction de la température.

9. Circuit selon l'une des revendications précédentes, caractérisé en ce que le détecteur de température (14) est monté sur un radiateur de(s) étage(s) de sortie.

10. Circuit selon la revendication 1, caractérisé en ce que la sortie des étages de sortie (2), commandés est reliée par une diode (26) à un pôle de la source de tension de fonctionnement, la diode (16) étant polarisée pour qu'en fonctionnement elle bloque l'étage de sortie.